# EUROPÄISCHE PATENTANMELDUNG

(11) **EP 0 971 238 A2**
(43) Veröffentlichungstag der Anmeldung: **12.01.2000**
(21) Anmeldenummer: 99113118.6
(22) Anmeldetag: 07.07.1999
(51) Int. Cl.: G01R 31/11

(54) **Verfahren und Vorrichtung zur richtungsabhängigen Fehlerortung oder Nachrichtenübertragung auf Niederspannungsnetzen im Betriebszustand**

(30) Priorität: 09.07.1998 DE 19830738
(71) Anmelder: Seba-Dynatronic Mess- und Ortungstechnik GmbH, 96148 Baunach (DE)
(72) Erfinder: Bellen, Otto, D-67862 Kindsbach (DE); Kreutzer, Martin, Dr.Ing., D-66424 Hamburg (DE); Schlapp, Hubert, Ing., D-96106 Ebem (DE)
(74) Vertreter: Riebling, Peter, Dr.-Ing.

(57) **Zusammenfassung**

Die vorliegende Erfindung betrifft ein Verfahren und eine Vorrichtung zur richtungsabhängigen Ortung von Fehlern in Niederspannungsnetzen sowie zur richtungsabhängigen Nachrichtenübertragung in Niederspannungsnetzen.

## Beschreibung

Die Erfindung betrifft ein Verfahren und eine Vorrichtung zur richtungsabhängigen Fehlerortung und Nachrichtenübertragung auf sich im Betriebszustand befindlichen Niederspannungsnetzen nach den Oberbegriffen der Patentansprüche 1 und 7.

Zur Ortung von Fehlern in Niederspannungsnetzen ist es bekannt, an das Niederspannungsnetz ein Laufzeitmeßgerät anzuordnen, welches einen Impuls in die zu untersuchende Leitung hineinsendet. Man arbeitet also nach dem Impuls-Echo-Verfahren. Grundsätzlich besteht die Möglichkeit, im stillgelegten Zustand des Kabels zu messen, dabei trennt man jenseits des Laufzeitmeßgerätes liegende Teile der Leitung ab, um zu vermeiden, daß das vom Kabelfehler zurückgesendete Echosignal in die jenseits des Laufzeitmeßgerätes angeordneten, rückwärtigen Betriebsteile der Einrichtung gelangt. Es soll im übrigen verhindert werden, daß der vom Laufzeitmeßgerät ausgesendete Impuls über die rückwärtigen Betriebseinrichtungen in unerwünschter Weise reflektiert wird und fehlerhaft von dem Laufzeitmeßgerät als Kabelfehlerecho interpretiert wird.

Um dies auch im stromführenden Betriebszustand zu vermeiden ist es bekannt, den vorderen Teil der Leitung (den zu messenden Teil) von dem rückwärtigen Teil dadurch zu trennen, daß in den Leitungsteil rückseitig von dem Laufzeitmeßgerät eine Impulssperre in Form einer Längsinduktivität eingebaut wird. Diese Längsinduktivität hat einen Betrag von etwa 2 -5 mH.

Wegen des hohen Stromes, der im Betriebszustand fließt, besitzt die Induktivität zwangsläufig ein hohes Kupfer-/ Eisengewicht wodurch schwerwiegende Nachteile entstehen.

Bezüglich der Nachrichtenübertragung (Ein- und Auskopplung, bzw. Senden und Empfangen von Nachrichtensignalen) über stromführende Niederspannungsnetze besteht hinsichtlich der Entkopplung der beiden Richtungen auf dem Kabel die gleiche Problematik wie bei der Fehlerortung nach dem Implulsechoverfahren. Eine fehlende Entkopplung würde auch hier zu untolerierbaren Fehlern führen und die zur Richtungsentkopplung erforderlichen Maßnahmen wären mit gleichem Aufwand und gleichen Kosten verbunden.

Der vorliegenden Erfindung liegt deshalb die Aufgabe zugrunde, eine Vorrichtung und ein Verfahren zur richtungsabhängigen Ein- und Auskopplung von elektrischen Signalen (Fehlerortungsimpulse oder Nachrichtenimpulse) an stromführenden Niederspannungsnetzen so weiterzubilden, daß mit geringem Schaltungsaufwand und bei geringen Kosten ein richtungsabhängiges Senden und Empfangen von Nachrichten in sich im Betriebszustand befindlichen Niederspannungsnetzen ermöglicht wird.

Zur Lösung der gestellten Aufgabe ist die Erfindung durch die technische Lehre der Ansprüche 1 und 7 gekennzeichnet.

Die vorliegende Erfindung beseitigt nun alle Nachteile herkömmlicher Richtkoppler, wie sie beispielsweise beim Einsatz als Ankopplungseinrichtung für ein Impuls-Echomeßgerät an Niederspannungskabeln zur richtungsabhängigen Fehlerortbestimmung bestehen würden und auch alle Nachteile tatsächlich existierender, stets großvolumiger und schwerer Ankopplungseinrichtungen. Sie beschreibt eine Ankopplungseinrichtung, mit der gleichzeitig richtungsabhängig gesendet und empfangen werden kann, die ein Gewicht von nur einigen hundert Gramm besitzt und außerdem noch durch eine sehr hohe Stromtragfähigkeit von mehreren hundert Ampère sowie einen hohen Koppelfaktor gekennzeichnet ist. Die Ankopplungseinrichtung kann beispielsweise für die Zeit der Fehlerortung bzw. der Signalübertragung z. B. gegen eine Sicherung ausgetauscht werden.
Die Ankopplungseinrichtung arbeitet grundsätzlich nach dem Prinzip eines Richtkopplers. Ein Richtkoppler besteht immer aus einer Hauptleitung und einer Nebenleitung (Koppelleitung), die miteinander induktiv und kapazitiv verkoppelt sind. Die Vorteile gegenüber herkömmlichen Richtkopplern werden in der vorliegenden Erfindung erzielt durch die Realisierung der induktiven Kopplung zwischen Haupt- und Nebenleitung mit Hilfe eines speziell hierfür entwickelten Übertragers ohne magnetisch aktives Kernmaterial bei einem gleichwohl sehr hohen Koppelfaktor. Darüber hinaus wird im Vergleich zur Schaltung nach dem Stand der Technik ein Übertrager und, im Vergleich mit einer anderen bekannten Schaltung, ein Kondensator und ein Widerstand eingespart.

Wesentlich ist, daß nun erfindungsgemäß ein Richtkoppler verwendet wird, der aus einer induktiven Kopplungseinrichtung im Längszweig zur Erfassung des Stromes besteht und einem Kopplungskondensator, welcher die Spannung von der Hauptleitung auf die Nebenleitung kapazitiv auskoppelt.

Der Erfindungsgegenstand der vorliegenden Erfindung ergibt sich nicht nur aus dem Gegenstand der einzelnen Patentansprüche, sondern auch aus der Kombination der einzelnen Patentansprüche untereinander.

Alle in den Unterlagen, einschließlich der Zusammenfassung, offenbarten Angaben und Merkmale, insbesondere die in den Zeichnungen dargestellte räumliche Ausbildung werden als erfindungswesentlich beansprucht, soweit sie einzeln oder in Kombination gegenüber dem Stand der Technik neu sind.

Im folgenden wird die Erfindung anhand von mehrere Ausführungswege darstellenden Zeichnungen am Beispiel der Fehlerortung näher erläutert. Hierbei gehen aus den Zeichnungen und ihrer Beschreibung weitere erfindungswesentliche Merkmale und Vorteile der Erfindung hervor.

Es zeigen:
- Figur 1:: Schematisiert die Anwendung eines Richtkopplers nach der Erfindung.
- Figur 2:: Eine Ausführung einer Schaltung eines Richtkopplers in einem ersten Ausführungsbeispiel.
- Figur 3:: Die Ausführung eines Richtkopplers in einer Schaltung nach einem zweiten Ausführungsbeispiel.

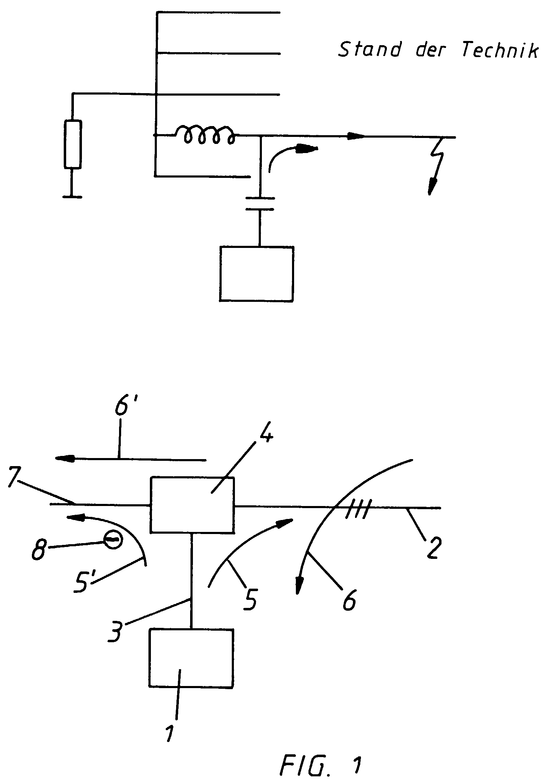

Allgemein kann in Figur 1 angegeben werden, daß auf einer Hauptleitung 2, die z. B. als dreiphasige Leitung ausgebildet ist, ein Fehler mittels eines Impuls-Echomeßgerätes gefunden werden soll. Es wird hierbei immer nur eine Phase der Hauptleltung 2 betrachtet und entsprechend geprüft.

Es ist schematisiert dargestellt, daß das Impuls-Echo-Meßgerät 1 über die gegebenenfalls mehradrige Leitung 3 einen Impuls in Pfeilrichtung 5 über den erfindungsgemäßen Richtkoppler 4 auf die Hauptleitung 2 einkoppelt, wobei dieser Impuls 5 nur in Vorwärtsrichtung (in Figur 1 nach rechts) die Hauptleitung 2 entlangschreiten soll.

Dieser Sendeimpuls 5 soll in Richtung auf die rückwärtige Leitung 7 gesperrt werden; dies ist so dargestellt, daß für den rückwärtig sich ausbildenden Sendeimpuls 5' ein Sperrsymbol 8 eingezeichnet ist.

Der auf der zu prüfenden Ader befindliche Kabelfehler reflektiert den Sendeimpuls 5 als Echosignal 6 und schickt dieses wieder auf den Richtkoppler 4 zurück. Wichtig ist nun, daß dieses reflektierte Echosignal 6 nun von dem Richtkoppler 4 ausgekoppelt wird und dem Impuls-Echomeßgerät 1 zur Auswertung zugeführt wird.

Es ist gleichzeitig dargestellt, daß dieses Echosignal 6 auch in Form des Echosignals 6' durch den Richtkoppler 4 hindurchgeht und auch den rückwärtigen Teil der Leitung 7 beaufschlagt.

Dies spielt aber keine Rolle, weil der Richtkoppler 4 von Seiten der rückwärtigen Leitung 7 das Echosignal 6' unterdrückt und nicht erfaßt.

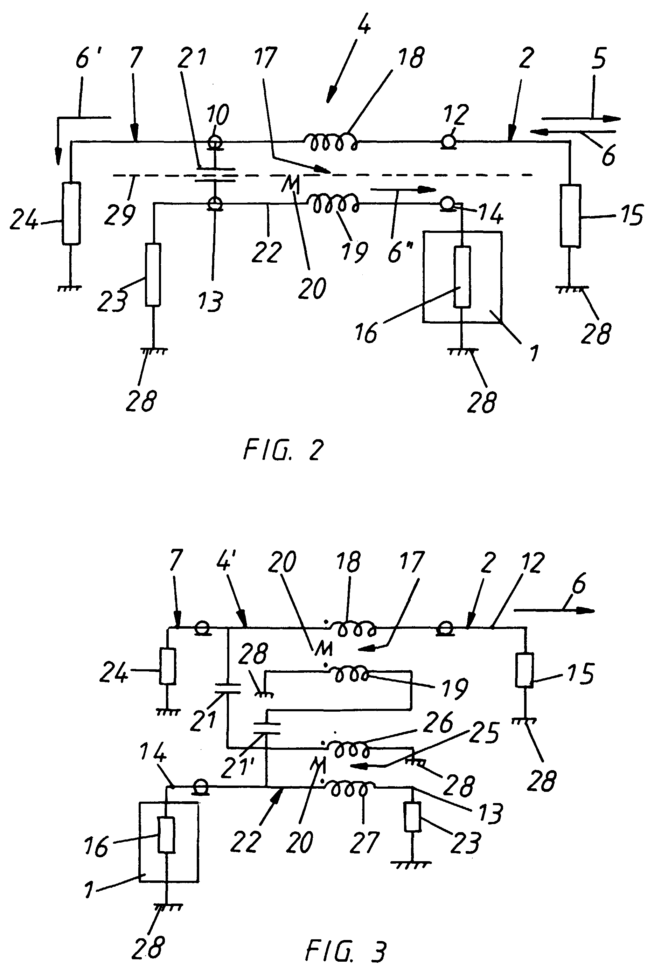

Dies wird durch eine erfindungsgemäße Schaltung erreicht, wie sie in den Figuren 2 und 3 näher dargestellt ist.

Die Figur 2 zeigt eine erste Ausführungsform einer derartigen Schaltung, wo symbolisch dargestellt ist, daß die Hauptleitung 2 einen Wellenwiderstand 15 aufweist, der gegenüber Masse 28 oder Bezugsleiter wirkt.

Die Hauptleitung 2 ist hierbei über die Klemme 12 an den Richtkoppler 4 angeschaltet.

Der rückwärtige Teil der Leitung 7 ist ebenfalls als Hauptleitung 2 ausgebildet und ist an der Klemme 10 angeschlossen und hat hierbei den Wellenwiderstand 24 gegenüber der Masse 28 oder Bezugsleiter.

Im Normalfall sind die beiden Wellenwiderstände 15, 24 etwa gleich groß.

Erfindungsgemäß besteht der Richtkoppler nun aus einem in dem Serienzweig angeordneten Stromwandler 17, dessen Primärinduktivität 18 direkt in der Hauptleitung 2 zwischen den Klemmen 10 und 12 eingeschaltet ist.

Er ist über eine Kopplungsinduktivität 20 über eine Luftkoppelstrecke mit der Sekundärinduktivität 19 gekoppelt, wodurch die Einkopplung von der Hauptleitung auf die parallel dazu geführte Nebenleitung bezüglich des Stroms erfolgt. Über diesen Stromwandler 17 wird also nur der Strom von der Hauptleitung 2 auf die Nebenleitung 22 ausgekoppelt. Die Spannungsauskopplung erfolgt hierbei über einen Koppelkondensator 21, der zwischen der Klemme 10 in der Hauptleitung 2 und einer Klemme 13 in der Nebenleitung 22 eingeschaltet ist.

Die Sekundärinduktivität 19 ist ebenfalls in Serie in die Nebenleitung 22 geschaltet und verläuft von Klemme 13 bis Klemme 14.

An der Klemme 14 ist gegenüber Masse 28 das Impuls-Echo-Meßgerät 1 eingeschaltet, welches eine Innenimpedanz 16 aufweist.

Es ist nicht dargestellt, daß das Impuls-Echo-Meßgerät 1 noch mit einem Impulsgenerator versehen ist, der in der Lage ist, den vorher erwähnten Sendeimpuls 5 zu erzeugen und an Klemme 14 des Richtungskopplers einzuspeisen.

Auf der gegenüberliegenden Seite zu dem Impuls-Echo-Meßgerät 1 ist eine Abschlußimpedanz 23 zwischen der Klemme 13 und der Masse 28 vorgesehen, die in ihrem Wert etwa der Innenimpedanz 16 des Impuls-Echo-Meßgerätes 1 entspricht.

Es werden also Strom und Spannung mit getrennten Bauteilen von der Hauptleitung 2 auf die Nebenleitung 22 ausgekoppelt. Zur Stromauskopplung dient der Stromwandler 17 und zur Spannungsauskopplung der Koppelkondensator 21.

Im Sendebetrieb wird der Sendeimpuls, der von dem Impuls-Echomeßgerät 1 ausgesendet wird über den Stromwandler 17 und den Koppelkondensator 21 in die Hauptleitung 2 eingekoppelt.

Der Einfachheit halber wird nun der Empfangsfall geschildert, wie nämlich der erfindungsgemäße Richtkoppler 4 das vom Kabelfehler aus der Vorwärtsrichtung reflektierte Echosignal erfaßt und dem Impuls-Echo-Meßgerät 1 zugeführt, ein aus dem rückwärtigen Leitungsteil kommendes Signal aber unterdrückt wird. Das Echosignal 6 erscheint an der Klemme 12. Dieses Echosignal 6 ist als Welle zu bezeichnen, d. h. ein kombiniertes Strom- und Spannungssignal, welches die Primärinduktivität 18 des Stromwandlers 17 durchfließt. Der Strom wird durch den Stromwandler erfaßt und über die Koppelinduktivität 20 auf der Sekundärinduktivität 19 als Spannungswert abgebildet. An den Abschlußimpedanzen 16 und 23 erscheint dieses Spannungssignal des Echosignal 6'' jeweils mit umgekehrter Polarität gegenüber Masse.

Die Spannungskomponente des Echosignals 6 auf der Hauptleitung 2 wird über den Koppelkondensator 21 zwischen den Klemmen 10 und 13 ausgekoppelt und führt an den Impedanzen 16 und 23 jeweils zu einer gleichgroßen und gleichgerichteten Spannung.

An jeder Impedanz 16 und 23 sind jeweils zwei Spannungen überlagert, nämlich die Spannung, die durch den Stromanteil des Echosignals erzeugt wurde und die Spannung, die durch den Spannungsanteil des Echosignals erzeugt wurde.

Wandert nun die Welle in Form des Echosignals 6'' in der eingezeichneten Pfeilrichtung auf der Nebenleitung 22 in Richtung auf das Impulsmeßgerät 1, dann erzeugt sie im Impulsmeßgerät 1 und dessen Impedanz 16 ein sich überlagerndes und sich damit addierendes Spannungssignal, welches somit im Impuls-Echomeßgerät ausgewertet werden kann. Umgekehrt wird diese Spannung in entgegengesetzter Richtung in der Abschlußimpedanz 23 einlaufen und dort vollkommen ausgelöscht werden. Strom und Spannung kompensieren sich damit in der Abschlußimpedanz 23.

Kommt nun ein störender Impuls von der rückwärtigen Leitung 7 in Richtung nach vorne (Pfeilrichtung 5) so erfolgt die Auskopplung nach dem gleichen Prinzip, d. h. es erfolgt eine Spannungsauskopplung am Koppelkondensator 21 und eine Stromauskopplung am Stromwandler 17. Nur wird hier im Vergleich zu dem vorher genannten Ausführungsbeispiel bei dem Stromwandler ein entgegengesetzter Spannungspfeil erzeugt, während bei dem Koppelkondensator 21 ein gleichgerichteter - wie im vorher gezeigten Ausführungsbeispiel - Spannungspfeil erzeugt wird. Dies führt nun dazu, daß an der Innenimpedanz 16 des Impuls-Echo-Meßgerätes die Auslöschung der Spannungspfeile erfolgt und kein Signal erfaßt wird, während an der Abschlußimpedanz 23 die Signale sich addieren; aber nicht vom Meßgerät erfaßt werden.

Damit ist die Funktion des Richtkopplers eindeutig beschrieben, es wird nun im folgenden die Einkopplung des Sendeimpulses von dem Impuls-Echo-Meßgerät von der Nebenleitung 22 auf die Hauptleitung 2 geschildert.

Weil der Sendeimpuls an der Klemme 14 eingespeist wird, erscheint dieser dann an der Klemme 12, nicht aber an der Klemme 10.

Nachdem der Koppler über die Längsmittenlinie 29 vollsymmetrisch ist, funktioniert das Senden nach dem entsprechend vorher anhand der empfangenen Signale geschilderten Prinzipien auf analoge Weise. Für diesen Anwendungsfall kann man sich vorstellen, daß die Begriffe 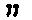 Haupt-" und 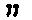 Nebenleitung" vertauscht sind. Ansonsten gelten die gleichen Erläuterungen wie sie vorstehend gegeben wurden. Dies folgt daraus, daß auf Grund der Symmetrie es Richtkopplers entlang der Längsmittenlinie 29 Haupt- und Nebenleitung ohne Weiteres zu vertauschen sind.

Man erkennt nämlich, daß die Impedanzen 24 und 23 genau symmetrisch zueinander sind wie zu den Impedanzen 15 und 16. Die gesamte Schaltung ist demzufolge längs der Längsmittenlinie 29 spiegelsymmetrisch ausgebildet.

Der Koppelkondensator 21 ändert an dieser Symmetrie nichts, weil er gleichberechtigt die beiden symmetrischen Zweige zwischen den Klemmen 10 und 13 verbindet und auf der Symmetrielinie 29 liegt.

Eine Variante der in Figur 2 dargestellten Schaltung wird nun anhand der Figur 3 erläutert, wobei die gleichen Teile mit den gleichen Bezugszeichen bezeichnet wurden. Der hier dargestellte Stromwandler 17 hat wiederum die Aufgabe, den von der Hauptleitung 2 eintreffenden Echoimpuls 6 mit seinen Stromanteilen auszukoppeln, während wiederum der Koppelkondensator 21 der die Aufgabe hat, den Spannungsanteil dieses Echosignals 6 auszukoppeln.

Auf der Sekundärseite des Stromwandlers 17, nämlich bei der Sekundärinduktivität 19, wird eine Spannung erzeugt, die eine Abbildung des Stromes durch die Primärinduktivität 18 im Stromwandler 17 ist. Diese Spannung wird kapazitiv über den Koppelkondensator 21' auf die Nebenteitung 22 gekoppelt.

In analoger Weise erfolgt die Spannungsauskopplung des Spannungsanteils des Echosignals 6 über den Koppelkondensator 21, der aber in Serie mit der Primärinduktivität 26 eines weiteren Stromwandlers 25 verbunden ist. Hier erfolgt die Auskopplung über die Koppelinduktivität 20 auf die sekundäre Induktivität 27 die in Serie in der Nebenleitung 22 liegt als Spannungssignal.

Ansonsten gelten die gleichen Erläuterungen, daß nämlich die Innenimpedanz 16 des Impuls-Echomeßgerätes 1 annähernd gleich der Abschlußimpedanz 23 am anderen Ende der Nebenleitung 22 entspricht. Es gelten dann bezüglich der Nebenleitung sowohl für den Empfangs- als auch für den Sendebetrieb die gleichen Erläuterungen wie sie obenstehend anhand der Schaltungsfigur 2 gegeben wurden, nur daß in der Nebenleitung in Figur 2 die sekundäre Induktivität 19 eingeschaltet war, während im vorliegenden Ausführungsbeispiel die sekundäre Induktivität 27 eines zweiten Stromwandlers 25 eingeschaltet ist.

Besonderer Vorteil der gezeigten Schaltungen ist die sehr hohe Stromtragfähigkeit des Richtkopplers 4 bei gleichzeitig höchstmöglicher Kopplung zwischen der Hauptleitung und der Nebenleitung.

Der Sendeimpuls 5, der im Falle der Fehlerortung als 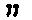 Fehlerortungsimpuls" bezeichnet werden kann, ist im Falle der Nachrichtenübertrageung ein 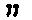 Nachrichten-Sendeimpuls 5". Dem Echoimpuls 6 bei der Fehlerortung entspricht im Falle der Nachrichtenübertraggung ein 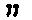 Nachrichten-Empfangsimpuls 6''. Bei der Fehlerortung sind Sender und Empfänger im Impuls-Echo-Meßgerät 1 integriert, bei der Nachrichtenübertragung wird an Stelle des Richtkopplers eine Nachrichten-Sende-/Empfangseinheit angeschlossen.

Zur einfachen Berechnung der Schaltung kann davon ausgegangen werden, daß in einem bevorzugten Ausführungsbeispiel alle gezeigten Impedanzen möglichst gleich groß sind.

### Zeichnungslegende

- 1: Impuls-Echomeßgerät
- 2: Hauptleitung
- 3: Leitung
- 4: Richtkoppler 4'
- 5: Sendeimpuls 5'
- 6: Echosignal 6', 6''
- 7: rückwärtige Leitung
- 8: Sperrsymbol
- 9:
- 10: Klemme
- 11: Klemme
- 12: Klemme
- 13: Klemme
- 14: Klemme
- 15: Wellenwiderstand Hauptleitung (vorwärts)
- 16: Innenimpedanz des Impuls-Echomeßgeräts
- 17: Stromwandler
- 18: Primärinduktivität
- 19: Sekundärinduktivität
- 20: Kopplungsinduktivität
- 21: Koppelkondensator 21'
- 22: Nebenleitung
- 23: Abschlußimpedanz
- 24: Wellenwiderstand Hauptleitung (rückwärts)
- 25: Stromwandler
- 26: Primärinduktivität
- 27: Sekundärinduktivität
- 28: Masse
- 29: Längsmittenlinie

## Patentansprüche

1. Verfahren zur richtungsabhängigen Fehlerortung in Niederspannungsnetzen, ***dadurch gekennzeichnet,*** daß eine Ankopplungseinrichtung in Form eines Richtkopplers (4) mit hoher Stromtragfähigkeit und gleichzeitig hohem Koppelfaktor elektrische Impule (5, 6) an einer sich im stromtragenden Betriebszustand befindlichen Niederspannungsleitung (2) richtungsabhängig senden und empfangen kann.

2. Verfahren nach Anspruch 1, **d*adurch gekennzeichnet,*** daß der Richtkoppler (4) im Falle der Fehlerortung einen Sendeimpuls (5) in Richtung des vermuteten Leitungsfehlers der zu prüfenden Leitung an der Meßstelle an der Klemme (12) absendet und das vom Leitungsfehler reflektierte Echosignal (6) wieder an das Impuls-Echomeßgerät (1) zur Auswertung zurückgibt, und den Sendeimpuls (5) für die rückwärtige Leitung (7) an der Klemme (10) der Meßstelle sperrt.

3. Verfahren nach Anspruch 1, ***dadurch gekennzeichnet,*** daß der Richtkoppler (4) im Falle der Nachrichtenübertragung Nachrichtenimpulse (5) in Richtung des fernen Empfängers an der Klemme (12) absendet und gleichzeitig Nachrichtenimpulse (6) nur aus dieser Richtung empfängt.

4. Verfahren nach einem der Ansprüche 1 bis 3, ***dadurch gekennzeichnet,*** daß die Stromankopplung des Richtkopplers (4) durch eine induktive Kopplung zwischen Hauptleitung (2) und Nebenleitung (22) mit Hilfe einer Übertragers ohne magnetisch aktives Kernmaterial bei sehr hohem Koppelfaktor realisiert ist.

5. Verfahren nach einem der Ansprüche 1 bis 4, ***dadurch gekennzeichnet**,* daß die Ankopplungseinrichtung auch während eines Fehlerzustandes des Niederspannungsleitungssystems zu Meß- und Übertragungszwecken eingesetzt werden kann.

6. Verfahren nach einem der Ansprüche 1 bis 5, ***dadurch gekennzeichnet,*** daß Ankopplungseinrichtung im Induktivitäten funktioniert, die eine Stromtragfähigkeit von mehreren hundert Ampère bei gleichzeitig hohem Koppelfaktor aufweisen und zusätzlich nur ein sehr geringes Gewicht von einigen hundert Gramm besitzen.

7. Vorrichtung zur richtungsabhängigen Fehlerortung oder Nachrichtenübertragung in Niederspannungsnetzen, ***dadurch gekennzeichnet,*** daß ein Richtkoppler (4) in Serie an einer Stelle in ein Niederspannungsleitungssystem mit seiner Primärinduktivität (18) an den Klemmen (10 und 12) eingekoppelt wird und mit seiner Sekundärinduktivität (19) und der Kopptungsinduktivität (20) in Zusammenwirkung mit einem Koppelkondensator (21) zwischen den Klemmen (10 und 13) die Ankopplung der Nebenleitung (22) zur Hauptleitung (2) bewirkt.

8. Vorrichtung nach Anspruch 7, ***dadurch gekennzeichnet**,* daß der Stromwandler (17) des Richtkopplers (4) die Stromkopplung bei der Messung ausführt und der Koppelkondensator (21) zwischen den Klemmen (10 und 13) die Spannungsankopplung des Richtkopplers (4) durchführt.

9. Vorrichtung nach einem der Ansprüche 7 und 8, ***dadurch gekennzeichnet,*** daß im Falle der Fehlerortung an der Klemme (14) gegenüber der Masse (28) ein Impuls-Echomeßgerät (1) angeschlossen ist, das Sendeimpulse (5) über den Richtkoppler (4) in das Niederspannungsleitungssystem einkoppelt und das rücklaufende Echosignal (6) wieder über den Richtkoppler (4) zurückerhält und auswertet.

10. Vorrichtung nach einem der Ansprüche 7 und 8, ***dadurch gekennzeichnet,*** daß im Falle der Nachrichtenübertragung an der Klemme (14) gegenüber der Masse (28) eine Sende-/Empfangseinheit (1 ) angeschlossen ist, die Sendeimpulse (5) über den Richtkoppler (4) in das Niederspannungsnetz einkoppelt und Empfangssignale (6) wieder über den Richtkoppler (4) empfängt.

11. Vorrichtung nach einem der Ansprüche 7 bis 10, ***dadurch gekennzeichnet,*** zwischen der Klemme (13) und der Masse (28) eine Abschlußimpedanz angeordnet ist, deren Wert in etwa der Innenimpedanz (16) des Impuls-Echomeßgerätes (1) entspricht.

12. Vorrichtung nach einem der Ansprüche 7 bis 11, ***dadurch gekennzeichnet,*** daß der Primär- und der Sekundärbereich des Richtkopplers (4) symmetrisch zueinander aufgebaut sind.

13. Vorrichtung nach einem der Ansprüche 7 bis 12, ***dadurch gekennzeichnet,*** daß der Richtkoppler (4'') aus jeweils zwei Primärinduktivitäten (18 und 26), sowie aus jeweils zwei Sekundärinduktivitäten (19 und 27), mit deren Kopplungsinduktivitäten (20) und Kopplungskondensatoren (21 und 21') besteht.

14. Vorrichtung nach einem der Ansprüche 7 bis 13, **d*adurch gekennzeichnet,*** daß die Spannungsankopplung des Spannungsanteils des Echosignals (6) über den Koppelkondensator (21) und der Primärinduktivität (26) über die Koppelinduktivität (20) auf die Sekundärinduktivität (27) übertragen wird und daß die Spannungsankopplung des Stromanteils des Echosignals (6) über die Primärinduktivität (18) die Kopplungsinduktivität (20) auf die Sekundärinduktivität (19) und weiter auf den Koppelkondensator (21') übertragen wird.
